(19)

Europäisches Patentamt
European Patent Office
Office européen des brevets

(11) **EP 4 148 950 B1**

(12) **EUROPEAN PATENT SPECIFICATION**

(45) Date of publication and mention of the grant of the patent:
**19.11.2025 Bulletin 2025/47**

(21) Application number: **22742924.8**

(22) Date of filing: **25.01.2022**

(51) International Patent Classification (IPC):
$H02J\ 7/00^{(2006.01)}$    $H01M\ 10/48^{(2006.01)}$
$G01R\ 31/367^{(2019.01)}$    $G01R\ 31/36^{(2020.01)}$
$G01R\ 31/382^{(2019.01)}$    $G01R\ 31/392^{(2019.01)}$
$G01R\ 19/165^{(2006.01)}$    $G01R\ 19/10^{(2006.01)}$
$G01R\ 1/40^{(2006.01)}$

(52) Cooperative Patent Classification (CPC):
**H02J 7/005;** G01R 31/392; H02J 7/007182; Y02E 60/10

(86) International application number:
**PCT/KR2022/001330**

(87) International publication number:
**WO 2022/158948 (28.07.2022 Gazette 2022/30)**

(54) **BATTERY MANAGEMENT APPARATUS AND METHOD**

BATTERIEVERWALTUNGSVORRICHTUNG UND -VERFAHREN

DISPOSITIF ET PROCÉDÉ DE GESTION DE BATTERIE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.01.2021 KR 20210010308**

(43) Date of publication of application:
**15.03.2023 Bulletin 2023/11**

(73) Proprietor: **LG Energy Solution, Ltd.**
**Seoul 07335 (KR)**

(72) Inventors:
• **BAE, Yoon-Jung**
 **Daejeon 34122 (KR)**
• **CHA, A-Ming**
 **Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(56) References cited:
WO-A1-2013/157132    JP-A- 2017 129 493
JP-A- 2018 206 612    JP-B2- 5 940 145
JP-B2- 5 940 145    KR-A- 20200 026 128
US-A1- 2011 012 604    US-A1- 2019 202 299

## Description

TECHNICAL FIELD

The present application claims priority to Korean Patent Application No. 10-2021-0010308 filed on January 25, 2021 in the Republic of Korea.

The present disclosure relates to a battery management apparatus and method, and more particularly, to a battery management apparatus and method capable of setting an operating condition of a battery based on a degradation state of the battery.

BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

However, the battery is degraded as the cycle increases (as the battery is operated more), and the performance of the battery may deteriorate due to the degradation. If the operating conditions set for a battery in a BOL (Beginning of Life) state are applied to the degraded battery without considering the degradation degree of the battery, the degraded battery may be overdischarged and/or overcharged. If the overdischarge and/or overcharge continues, battery degradation may be accelerated or unexpected accidents such as ignition or explosion may occur.

Therefore, in order to increase the life expectancy of the battery and to prevent unexpected accidents in advance, it is necessary to set an appropriate operating condition for the battery in consideration of the degradation state of the battery.

JP 5 940145 discloses a battery management judging the deteriorated state of a secondary battery.

DISCLOSURE

Technical Problem

The present disclosure is designed to solve the problems of the related art, and therefore the present disclosure is directed to providing a battery management apparatus and method for setting an operating condition of a battery based on a degradation state of the battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

Technical Solution

A battery management apparatus according to one aspect of the present disclosure may comprise: a profile generating unit configured to obtain battery information about capacity and voltage of a battery and generate a differential profile representing a corresponding relationship between the capacity and a differential voltage based on the capacity and the voltage; and a control unit configured to obtain the differential profile from the profile generating unit, detect a plurality of peaks in the obtained differential profile, calculate a degradation degree of the battery based on a capacity corresponding to each of the plurality of detected peaks, and set an upper limit of a charge termination voltage for the battery according to a result of comparing the calculated degradation degree with a preset criterion degradation degree.

The control unit may be configured to detect a first target peak and a second target peak in the differential profile, calculate a capacity deviation between a first target capacity corresponding to the first target peak and a second target capacity corresponding to the second target peak, and calculate the degradation degree based on the calculated capacity deviation and a criterion capacity deviation for a preset criterion profile.

The control unit may be configured to detect a peak included in a first capacity region of the criterion profile among the plurality of peaks as the first target peak and detect a peak included in a second capacity region of the criterion profile among the plurality of peaks as the second target peak.

The criterion capacity deviation may be set as a capacity deviation between a first criterion capacity of a first criterion peak corresponding to the first target peak in the criterion profile and a second criterion capacity of a second criterion peak corresponding to the second target peak.

The control unit may be configured to set the upper limit of the charge termination voltage as a BOL voltage preset for the battery, when the calculated degradation degree is less than the criterion degradation degree.

The control unit may be configured to set the upper limit of the charge termination voltage to be equal to or less than a preset criterion voltage, when the calculated degradation degree is equal to or greater than the criterion degradation degree.

The criterion voltage may be set as a voltage corresponding to a second criterion peak corresponding to the second target peak in the criterion profile.

The criterion voltage may be set as a voltage corresponding to a second criterion capacity of the second criterion peak.

When the calculated degradation degree is equal to or greater than the criterion degradation degree, the control unit may be configured to calculate a degradation deviation between the calculated degradation degree and the criterion degradation degree and set a voltage reduced in proportion to the degradation deviation from the criterion voltage as the upper limit of the charge termination voltage.

The control unit may be configured to diagnose the battery as an EOL state, when the calculated degradation deviation is equal to or greater than a preset threshold deviation.

A battery pack according to another aspect of the present disclosure may comprise the battery management apparatus according to an aspect of the present disclosure.

A battery management method according to still another aspect of the present disclosure may comprise: a differential profile generating step of generating a differential profile representing a corresponding relationship between a differential voltage based on capacity and voltage of a battery and the capacity; a plural peak detecting step of detecting a plurality of peaks in the differential profile; a battery degradation degree calculating step of calculating a degradation degree of the battery based on a capacity corresponding to each of the plurality of detected peaks; and a charge termination voltage upper limit setting step of setting an upper limit of a charge termination voltage for the battery according to a result of comparing the calculated degradation degree with a preset criterion degradation degree.

## Advantageous Effects

According to one aspect of the present disclosure, since the upper limit of the charge termination voltage for the battery is appropriately set in consideration of the degradation degree of the battery, there is an advantage that the degradation of the battery is prevented from being accelerated and the life expectancy of the battery may be increased.

In addition, since the upper limit of the charge termination voltage for the battery is set in a range that does not excessively limit the performance of the battery, the life expectancy and performance efficiency of the battery may be improved.

The effects of the present disclosure are not limited to the effects mentioned above, and other effects not mentioned will be clearly understood by those skilled in the art from the description of the claims.

## DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a diagram schematically showing a battery management apparatus according to an embodiment of the present disclosure.

FIG. 2 is a diagram schematically showing a differential profile and a criterion profile according to an embodiment of the present disclosure.

FIG. 3 is a diagram schematically showing an exemplary configuration of a battery pack according to another embodiment of the present disclosure.

FIG. 4 is a diagram schematically showing a battery management method according to still another embodiment of the present disclosure.

## BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

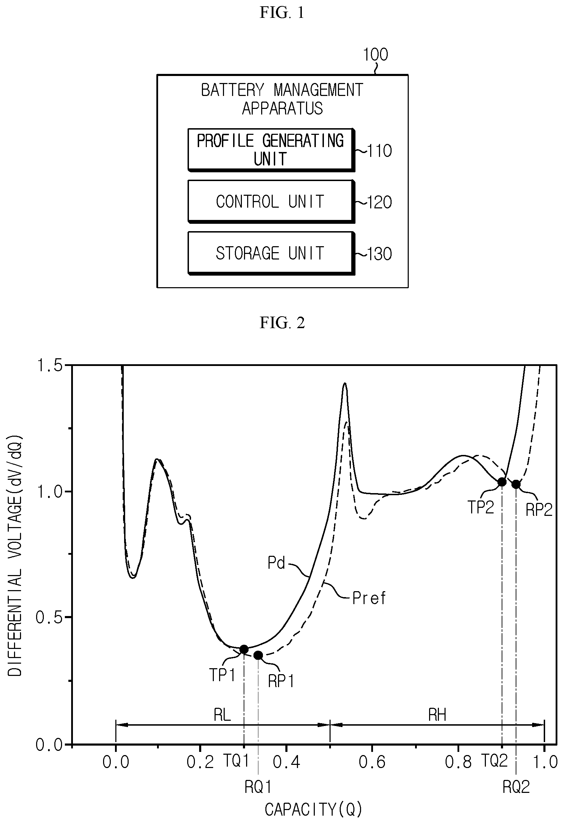

FIG. 1 is a diagram schematically showing a battery management apparatus 100 according to an embodiment of the present disclosure.

Referring to FIG. 1, the battery management apparatus 100 according to an embodiment of the present disclosure may include a profile generating unit 110 and a control unit 120.

The profile generating unit 110 may be configured to obtain battery information about capacity and voltage of a battery.

Here, the battery means one physically separable independent cell including a negative electrode terminal and a positive electrode terminal. For example, one lithium-ion battery or lithium polymer battery may be regarded as a battery.

For example, the profile generating unit 110 may obtain a battery profile representing a corresponding relationship between a capacity and a voltage of the battery. That is, the battery profile may include battery information in which the capacity and the voltage of the battery are mapped.

The profile generating unit 110 may be configured to generate a differential profile Pd representing a corresponding relationship between the capacity and a differential voltage based on the capacity and the voltage.

Here, the differential voltage is a value obtained by differentiating the voltage included in the battery information by the capacity, and may be expressed as "dV/dQ". That is, the differential voltage may be a value representing an instantaneous change rate of voltage with respect to capacity. The differential profile Pd will be described with reference to the embodiment of FIG. 2.

FIG. 2 is a diagram schematically showing a differential profile Pd and a criterion profile Pref according to an embodiment of the present disclosure.

In the embodiment of FIG. 2, the profile generating unit 110 may generate a differential profile Pd representing a corresponding relationship between the capacity and the differential voltage, based on the obtained battery information.

In addition, in the embodiment of FIG. 2, the criterion profile Pref may be a profile representing a corresponding relationship between a capacity for a BOL (Beginning of Life) battery and the differential voltage. Also, in the embodiment of FIG. 2, the capacity may be a relative capacity based on the capacity of the BOL battery.

The control unit 120 may be configured to obtain the differential profile Pd from the profile generating unit 110.

For example, the control unit 120 and the profile generating unit 110 may be connected to communicate with each other. The profile generating unit 110 may transmit the generated differential profile Pd to the control unit 120, and the control unit 120 may receive the differential profile Pd from the profile generating unit 110.

The control unit 120 may be configured to detect a plurality of peaks in the obtained differential profile Pd.

Here, the peak may be a point having a downward convex form in the differential profile Pd. That is, the peak is a point at which the change rate of the differential voltage with respect to capacity is 0. Based on the peak, the change rate may be negative at a low capacity side, and the change rate may be positive at a high capacity side.

Specifically, the control unit 120 may be configured to detect a peak included in a first capacity region RL of the criterion profile Pref among the plurality of peaks as the first target peak TP1.

For example, the first capacity region RL may mean a low capacity region among the entire capacity region of the criterion profile Pref. In the embodiment of FIG. 2, a capacity region of 0 or more and less than 0.5 may be preset as the first capacity region RL. In addition, the control unit 120 may detect a peak having the largest corresponding capacity among the plurality of peaks included in the first capacity region RL as the first target peak TP1. The detected first target peak TP1 may be a peak corresponding to a first target capacity TQ1.

Also, the control unit 120 may be configured to detect a peak included in the second capacity region RH of the criterion profile Pref among the plurality of peaks as the second target peak TP2.

For example, the second capacity region RH may mean a high capacity region among the entire capacity region of the criterion profile Pref. In the embodiment of FIG. 2, a capacity region of 0.5 or more and 1 or less may be preset as the second capacity region RH. In addition, the control unit 120 may detect a peak having the largest corresponding capacity among the plurality of peaks included in the second capacity region RH as the second target peak TP2. The detected second target peak TP2 may be a peak corresponding to a second target capacity TQ2.

That is, in the differential profile Pd and the criterion profile Pref included in the embodiment of FIG. 2, the capacity region may be normalized as 0 to 1 based on the total capacity of the BOL battery. Accordingly, a capacity region of 0 or more and less than 0.5 may be configured as the first capacity region RL that is a low capacity region, and a capacity region of 0.5 or more and 1 or less may be configured as the second capacity region RH that is a high capacity region.

The control unit 120 may be configured to calculate a degradation degree of the battery based on the capacity corresponding to each of the plurality of detected peaks.

Specifically, the control unit 120 may be configured to calculate a capacity deviation between the first target capacity TQ1 corresponding to the first target peak TP1 and the second target capacity TQ2 corresponding to the second target peak TP2. For example, in the embodiment of FIG. 2, the control unit 120 may calculate a capacity deviation between the first target capacity TQ1 and the second target capacity TQ2 by computing the formula of "TQ2 - TQ1".

In addition, the control unit 120 may be configured to calculate the degradation degree based on the calculated capacity deviation and a criterion capacity deviation for the preset criterion profile Pref.

Here, the criterion capacity deviation may be set as a capacity deviation between the first criterion capacity RQ1 of a first criterion peak RP1 corresponding to the first target peak TP1 in the criterion profile Pref and the second criterion capacity RQ2 of a second criterion peak RP2 corresponding to the second target peak TP2.

For example, in the embodiment of FIG. 2, the criterion profile Pref may include a first criterion peak RP1 and a second criterion peak RP2. The first criterion peak RP1 is a peak for the BOL battery, and may be a peak corresponding to the first target peak TP1. The second criterion peak RP2 is a peak for the BOL battery, and may be a peak corresponding to the second target peak TP2.

In addition, the control unit 120 may obtain a preset criterion capacity deviation or may directly calculate the criterion capacity deviation based on the criterion profile Pref. For example, the control unit 120 may calculate the criterion capacity deviation directly by computing the formula of "RQ2 - RQ1".

The control unit 120 may calculate the degradation degree of the battery by computing the ratio of the capacity deviation to the criterion capacity deviation. Specifically, the control unit 120 may calculate the degradation degree of the battery based on Formula 1 below.

[Formula 1]

$$D = \{1 - (TD \div RD)\} \times 100$$

Here, D is the degradation degree of the battery, and TD is the capacity deviation between the first target capacity TQ1 and the second target capacity TQ2. RD may be a criterion capacity deviation between the first criterion capacity RQ1 and the second criterion capacity RQ2. In addition, 100 may be a constant multiplied to express the unit of the calculated degradation degree as [%].

For example, in the embodiment of FIG. 2, it is assumed that the capacity deviation TD between the first target capacity TQ1 and the second target capacity TQ2 is 0.594, and the criterion capacity deviation RD between the first criterion capacity RQ1 and the second criterion capacity RQ2 is 0.607. The control unit 120 may calculate the degradation degree D of the battery as 2.14% by substituting the capacity deviation TD and the criterion capacity deviation RD in Formula 1.

The control unit 120 may be configured to set the upper limit of the charge termination voltage for the battery according to the result of comparing the calculated degradation degree and the preset criterion degradation degree.

Preferably, the upper limit of the charge termination voltage for the battery may be preset to a voltage corresponding to 100% SOC (State of Charge) of the BOL battery. For example, the upper limit of the charge termination voltage for the battery may be preset to 4.2 V. However, if the upper limit of the charge termination voltage is maintained at 4.2 V without considering the degradation degree of the battery, the battery life may be drastically reduced due to repeated overcharging.

Therefore, the battery management apparatus 100 according to an embodiment of the present disclosure has an advantage of increasing the life expectancy of the battery by appropriately setting the upper limit of the charge termination voltage for the battery based on the calculated degradation degree and the criterion degradation degree of the battery to prevent the degradation of the battery from being accelerated.

Meanwhile, the control unit 120 provided in the battery management apparatus 100 may selectively include processors known in the art, application-specific integrated circuit (ASIC), other chipsets, logic circuits, registers, communication modems, data processing devices, and the like to execute various control logic performed in the present disclosure. Also, when the control logic is implemented in software, the control unit 120 may be implemented as a set of program modules. At this time, the program module may be stored in a memory and executed by the control unit 120. The memory may be located inside or out of the control unit 120 and may be connected to the control unit 120 by various well-known means.

In addition, the battery management apparatus 100 may further include a storage unit 130. The storage unit 130 may store data necessary for operation and function of each component of the battery management apparatus 100, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

For example, the storage unit 130 may store the battery information representing a corresponding relationship between voltage and capacity of the battery. Also, the storage unit 130 may store the BOL battery information representing a corresponding relationship between voltage and capacity of the BOL battery. In addition, the profile generating unit 110 may access the storage unit 130 to obtain battery information, and generate a differential profile Pd for the battery based on the obtained battery information.

In addition, the storage unit 130 may store the differential profile Pd generated by the profile generating unit 110. The control unit 120 may directly receive the differential profile Pd from the profile generating unit 110, and may access the storage unit 130 to obtain the stored differential profile Pd. Also, the control unit 120 may access the storage unit 130 to obtain the battery information and the BOL battery information.

The control unit 120 may be configured to set the upper limit of the charge termination voltage to a preset BOL voltage for the battery, if the calculated degradation degree is less than the criterion degradation degree.

Here, the BOL voltage may be an upper limit of the charge termination voltage set for the BOL battery. That is, when the calculated degradation degree of the battery is less than the criterion degradation degree, the control unit 120 may not change the upper limit of the charge termination voltage for the battery in order to maximize the performance efficiency of the battery.

For example, it is assumed that the calculated battery degradation degree is 2% and the criterion degradation degree is 5%. In this case, the control unit 120 may not change the upper limit of the charge termination voltage for the battery. That is, the upper limit of the charge termination voltage for the battery may be maintained as the upper limit of the charge termination voltage for the BOL battery.

The control unit 120 may be configured to set the upper limit of the charge termination voltage to be less than or equal to the preset criterion voltage, when the calculated degradation degree is greater than or equal to the criterion degradation degree.

Here, the criterion voltage may be less than the BOL voltage. Specifically, the criterion voltage may be set to a voltage corresponding to the second criterion peak RP2 corresponding to the second target peak TP2 in the criterion profile Pref. For example, the criterion voltage may be set to a voltage corresponding to the second criterion capacity RQ2 of the second criterion peak RP2.

For example, it is assumed that the calculated degradation degree of the battery is 5% and the criterion degradation degree is 5%. In this case, the control unit 120 may set the upper limit of the charge termination voltage for the battery to a voltage corresponding to the second criterion capacity RQ2.

Specifically, the control unit 120 may obtain and store the BOL battery information representing a corresponding relationship between voltage and capacity for the BOL battery in advance, or may obtain the same by accessing the storage unit 130. In addition, the control unit 120 may select a voltage corresponding to the second criterion capacity RQ2 from the BOL battery information, and set the selected voltage as an upper limit of the charge termination voltage.

In the embodiment of FIG. 2, the second criterion peak RP2 may be a point at which a phase transition of the BOL battery ends and a phase equilibrium starts. Similarly, the second target peak TP2 may be the point at which the phase transition of the current battery ends and the phase equilibrium starts.

If the upper limit of the charge termination voltage of the battery is set based on the second target capacity TQ2, the upper limit of the set charge termination voltage may be affected by the overvoltage caused by the degradation of the battery. That is, there may be an error between the voltage corresponding to the second target capacity TQ2 and an actual voltage at which the phase equilibrium of the MOL battery starts due to the overvoltage for the battery in a MOL (Middle of Life) state.

For example, in the embodiment of FIG. 2, ideally, a voltage corresponding to the second criterion capacity RQ2 and a voltage corresponding to the second target capacity TQ2 may be the same. However, since an actually operated battery is affected by overvoltage according to degradation, the voltage corresponding to the second target capacity TQ2 may be different from the voltage corresponding to the second criterion capacity RQ2. Specifically, the voltage corresponding to the second target capacity TQ2 may be greater than the voltage corresponding to the second criterion capacity RQ2. Therefore, when setting the upper limit of the charge termination voltage based on the second target capacity TQ2, the upper limit of the charge termination voltage may be set as a voltage higher than the voltage corresponding to the point where the phase transition of the current battery ends (the point where the phase equilibrium starts). In other words, there is a possibility that the voltage at which phase equilibrium of the battery is in progress is set as the upper limit of the charge termination voltage. In this case, the battery may be charged up to the voltage at which the phase equilibrium proceeds, which may accelerate the degradation of the battery.

Therefore, in order to increase the life expectancy of the battery in consideration of the effect of overvoltage according to the degradation of the battery, the control unit 120 may set the upper limit of the charge termination voltage of the battery as a phase transition termination voltage of the BOL battery (a voltage corresponding to the second criterion capacity RQ2).

The battery management apparatus 100 according to an embodiment of the present disclosure may prevent rapid degradation of the battery and maintain the performance efficiency of the battery to the maximum by setting the voltage corresponding to the second criterion capacity RQ2 for the BOL battery as the upper limit of the charge termination voltage of the battery. That is, since the upper limit of the charge termination voltage for the battery is set in a range that does not excessively limit the performance of the battery, the life expectancy and the performance efficiency of the battery may be improved.

On the other hand, the second criterion peak RP2 and the second target peak TP2 appear not only when the content of nickel (Ni) included in the positive electrode material of the battery is high (e.g., 80% or more) but also when the content of nickel is low (e.g., less than 80%). This is because the criterion profile Pref is a profile representing a corresponding relationship between the capacity (Q) and the differential voltage (dV/dQ), and is a profile representing an instantaneous change rate of voltage based on capacity.

For example, in the embodiment of FIG. 2, the differential profile Pd and the criterion profile Pref are profiles for a battery in which the content of nickel included in the positive electrode material is 60% and the negative electrode material is graphite.

Contrary to the criterion profile Pref, when the nickel content is low (e.g., less than 80%), in the profile representing a corresponding relationship between the voltage (V) and the differential capacity (dQ/dV), a peak corresponding to the second criterion peak RP2 and the second target peak TP2 may not appear. When the second criterion peak RP2 and the second target peak TP2 do not appear, it is difficult to calculate the degradation degree of the battery, so the upper limit of the charge termination voltage for the battery may not be properly set.

Therefore, in an embodiment of the present disclosure, even when the nickel content included in the positive electrode material of the battery is low, the upper limit of the charge termination voltage for the battery may be appropriately set.

The control unit 120 may be configured to calculate a degradation deviation between the calculated degradation degree and the criterion degradation degree, when the calculated degradation degree is equal to or greater than the criterion degradation degree.

For example, the control unit 120 may calculate the degradation deviation by computing a difference between the calculated degradation degree and the criterion degradation degree.

[Formula 2]

$$DV = D - RD$$

Here, DV is the degradation deviation, D is the degradation degree of the battery calculated by Formula 1, and RD is the criterion degradation degree.

The control unit 120 may be configured to set a voltage reduced in proportion to the degradation deviation from the criterion voltage as an upper limit of the charge termination voltage.

For example, it is assumed that the calculated degradation degree of the battery is 6%, the criterion degradation degree is 5%, and the criterion voltage corresponding to the second criterion capacity RQ2 is 4.0 V.

The control unit 120 may calculate the degradation deviation as 1% by computing "battery degradation degree (6%) - criterion degradation degree (5%)". In addition, the control unit 120 may set 3.96 V, which is reduced in proportion to the degradation deviation (1%) from the criterion voltage, as an upper limit of the charge termination voltage for the battery.

That is, the control unit 120 may prevent rapid degradation of the battery and maintain high performance efficiency of the battery by reducing the upper limit of the charge termination voltage as the battery is degraded.

The control unit 120 may be configured to diagnose the battery as an EOL (End of Life) state, when the calculated degradation deviation is greater than or equal to a preset threshold deviation.

For example, the threshold deviation may be set to 15%. That is, when the degradation degree of the battery is greater than the criterion degradation degree by the threshold deviation or more, the control unit 120 may diagnose the battery as an unusable battery (EOL battery).

That is, the battery management apparatus 100 according to an embodiment of the present disclosure may prevent problems such as fire or explosion, which may be caused by operating a degraded battery, in advance by diagnosing a battery as an EOL state when the battery is degraded compared to the BOL battery the threshold deviation or more.

The battery management apparatus 100 according to the present disclosure may be applied to a BMS (Battery Management System). That is, the BMS according to the present disclosure may include the battery management apparatus 100 described above. In this configuration, at least some of the components of the battery management apparatus 100 may be implemented by supplementing or adding functions of the configuration included in the conventional BMS. For example, the profile generating unit 110, the control unit 120 and the storage unit 130 may be implemented as components of the BMS.

The battery management apparatus 100 according to the present disclosure may be provided in a battery pack. That is, the battery pack according to the present disclosure may include the above-described battery management apparatus 100 and one or more battery cells. In addition, the battery pack may further include electrical equipment (relays, fuses, etc.) and a case.

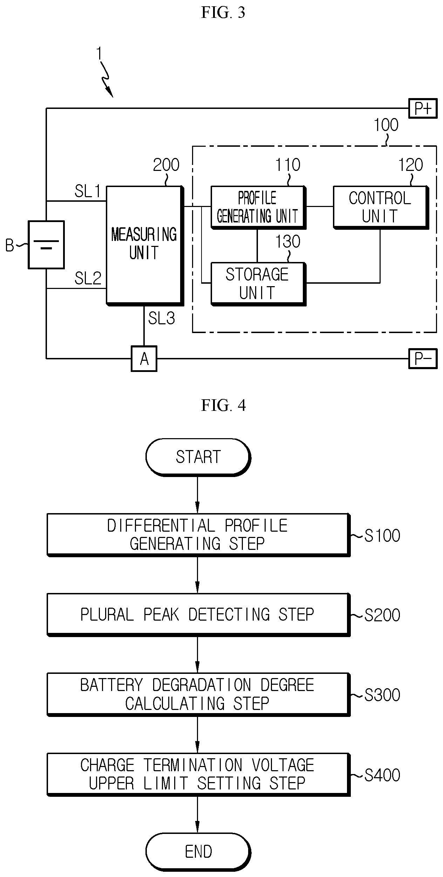

FIG. 3 is a diagram schematically showing an exemplary configuration of a battery pack 1 according to another embodiment of the present disclosure.

A measuring unit 200 may be connected to a first sensing line SL1, a second sensing line SL2, and a third sensing line SL3.

Specifically, the first sensing line SL1 may be connected to a positive electrode of a battery cell B and the measuring unit 200. Also, the second sensing line SL2 may be connected to a negative electrode of the battery cell B and the measuring unit 200. The measuring unit 200 may measure the voltage of the battery cell B by calculating the difference between the positive electrode voltage of the battery cell B measured through the first sensing line SL1 and the negative electrode voltage of the battery cell B measured through the second sensing line SL2.

Also, the measuring unit 200 may measure the charging current and/or the discharging current of the battery cell B through an ampere meter A connected to the third sensing line SL3. For example, the ampere meter A may be a shunt resistor or an ammeter.

The battery information about the voltage and current of the battery cell B measured by the measuring unit 200 may be transmitted to the battery management apparatus 100. Specifically, the profile generating unit 110 may receive the battery information of the battery cell B from the measuring unit 200. In addition, the profile generating unit 110 may generate a differential profile Pd representing a corresponding relationship between the capacity of the battery cell B and the differential voltage based on the received voltage and current of the battery cell B. In addition, the battery information of the battery cell B measured by the measuring unit 200 may be stored in the storage unit 130.

FIG. 4 is a diagram schematically showing a battery management method according to still another embodiment of the present disclosure.

Preferably, each step of the battery management method may be performed by the battery management apparatus 100. Hereinafter, contents overlapping with the previously described contents will be omitted or briefly described.

Referring to FIG. 4, the battery management method may include a differential profile Pd generating step (S100), a plural peak detecting step (S200), a battery degradation degree calculating step (S300), and a charge termination voltage upper limit setting step (S400).

The differential profile Pd generating step (S100) is a step of generating a differential profile Pd representing a corresponding relationship between the capacity and the differential voltage based on the capacity and voltage of the battery, and may be performed by the profile generating unit 110.

For example, in the embodiment of FIG. 2, the profile generating unit 110 may generate a differential profile Pd representing a corresponding relationship between the capacity of the battery and the differential voltage.

The plural peak detecting step S200 is a step of detecting a plurality of peaks in the differential profile Pd, and may be performed by the control unit 120.

For example, in the embodiment of FIG. 2, the control unit 120 may detect a first target peak TP1 in the first capacity region RL and detect a second target peak TP2 in the second capacity region RH. Here, the first capacity region RL may be a capacity region of 0 or more and less than 0.5 in the normalized capacity region, and the second capacity region RH may be a capacity region of 0.5 or more and 1 or less in the normalized capacity region.

The battery degradation degree calculating step (S300) is a step of calculating a degradation degree of the battery based on the capacity corresponding to each of the plurality of detected peaks, and may be performed by the control unit 120.

For example, in the embodiment of FIG. 2, the control unit 120 may calculate the degradation degree of the battery based on the first criterion capacity RQ1, the second criterion capacity RQ2, the first target capacity TQ1, and the second target capacity TQ2. Specifically, the control unit 120 may calculate the degradation degree by substituting the criterion capacity deviation (the capacity deviation between the first criterion capacity RQ1 and the second criterion capacity RQ2) and the capacity deviation (the capacity deviation between the first target capacity TQ1 and the second target capacity TQ2) in Formula 1.

The charge termination voltage upper limit setting step (S400) is a step of setting an upper limit of the charge termination voltage for the battery according to the result of comparing the calculated degradation degree with a preset criterion degradation degree, and may be performed by the control unit 120.

For example, when the calculated degradation degree is less than the criterion degradation degree, the control unit 120 may set the upper limit of the charge termination voltage for the battery as an upper limit of the charge termination voltage for the BOL battery.

As another example, when the calculated degradation degree is greater than or equal to the criterion degradation degree, the control unit 120 may set the upper limit of the charge termination voltage for the battery to be less than or equal to the criterion voltage. In the embodiment of FIG. 2, the criterion voltage may be a voltage corresponding to the second criterion capacity RQ2.

In addition, the control unit 120 may calculate a degradation deviation between the calculated degradation degree and the criterion degradation degree. In addition, the control unit 120 may set a voltage reduced in proportion to the degradation deviation from the criterion voltage as an upper limit of the charge termination voltage.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

(Reference Signs)

1: battery pack
100: battery management apparatus
110: profile generating unit
120: control unit
130: storage unit
200: measuring unit

**Claims**

1. A battery management apparatus (100), comprising:

   a profile generating unit (110) configured to obtain battery information about capacity and voltage of a battery and generate a differential profile representing a corresponding relationship between the capacity and a differential voltage based on the capacity and the voltage; and
   a control unit (120) configured to obtain the differential profile from the profile generating unit (110), detect a plurality of peaks in the obtained differential profile, calculate a degradation degree of the battery based on a capacity corresponding to each of the plurality of detected peaks, and set an upper limit of a charge termination voltage for the battery according to a result of comparing the calculated degradation degree with a preset criterion degradation degree,
   wherein the control unit (120) is configured to set the upper limit of the charge termination voltage to be equal to or less than a preset criterion voltage, when the calculated degradation degree is equal to or greater than the criterion degradation degree, and
   wherein the criterion voltage is set as a voltage corresponding to a second criterion peak corresponding to the second target peak in the criterion profile.

2. The battery management apparatus according to claim 1,
   wherein the control unit is configured to detect a first target peak and a second target peak in the differential profile, calculate a capacity deviation between a first target capacity corresponding to the first target peak and a second target capacity corresponding to the second target peak, and calculate the degradation degree based on the calculated capacity deviation and a criterion capacity deviation for a preset criterion profile.

3. The battery management apparatus (100) according to claim 2,
   wherein the control unit (120) is configured to detect a peak included in a first capacity region of the criterion profile among the plurality of peaks as the first target peak and detect a peak included in a second capacity region of the criterion profile among the plurality of peaks as the second target peak.

4. The battery management apparatus (100) according to claim 2,
   wherein the criterion capacity deviation is set as a capacity deviation between a first criterion capacity of a first criterion peak corresponding to the first target peak in the criterion profile and a second criterion capacity of a second criterion peak corresponding to the second target peak.

5. The battery management apparatus (100) according to claim 2,
   wherein the control unit (120) is configured to set the upper limit of the charge termination voltage as a BOL voltage preset for the battery, when the calculated degradation degree is less than the criterion degradation degree.

6. The battery management apparatus (100) according to claim 5,
   wherein the criterion voltage is set as a voltage corresponding to a second criterion capacity of the second criterion peak.

7. The battery management apparatus (100) according to claim 1,
   wherein when the calculated degradation degree is equal to or greater than the criterion degradation degree, the control unit (120) is configured to calculate a degradation deviation between the calculated degradation degree and the criterion degradation degree and set a voltage reduced in proportion to the degradation deviation from the criterion voltage as the upper limit of the charge termination voltage.

8. The battery management apparatus (100) according to claim 7,
   wherein the control unit (120) is configured to diagnose the battery as an EOL state, when the calculated degradation deviation is equal to or greater than a preset threshold deviation.

9. A battery pack (1), comprising the battery management apparatus (100) according to any one of claims 1 to 8.

10. A battery management method, comprising:

    a differential profile generating step of generating a differential profile representing a corresponding relationship between a differential voltage based on capacity and voltage of a battery and the capacity;
    a plural peak detecting step of detecting a plurality of peaks in the differential profile;
    a battery degradation degree calculating step of calculating a degradation degree of the battery based on a capacity corresponding to each of the plurality of detected peaks; and
    a charge termination voltage upper limit setting step of setting an upper limit of a charge termination voltage for the battery according to a result of comparing the calculated degradation degree with a preset criterion degradation degree,

wherein the charge termination voltage upper limit setting step includes setting the upper limit of the charge termination voltage upper limit to less than or equal to a preset reference voltage when the calculated degradation degree is greater than or equal to the criterion degradation degree,

wherein the control unit (120) is configured to set the upper limit of the charge termination voltage to be equal to or less than a preset criterion voltage, when the calculated degradation degree is equal to or greater than the criterion degradation degree, and

wherein the criterion voltage is set as a voltage corresponding to a second criterion peak corresponding to the second target peak in the criterion profile.

## Patentansprüche

1. Batteriemanagementvorrichtung (100) aufweisend:

   eine Profilerzeugungseinheit (110), die konfiguriert ist, um Batterieinformationen über Kapazität und Spannung einer Batterie zu erhalten und ein Differenzprofil zu erzeugen, das eine entsprechende Beziehung zwischen der Kapazität und einer Differenzspannung basierend auf der Kapazität und der Spannung darstellt; und

   eine Steuereinheit (120), die konfiguriert ist, um das Differenzprofil von der Profilerzeugungseinheit (110) zu erhalten, mehrere Höhepunkte in dem erhaltenen Differenzprofil zu erfassen, einen Verschlechterungsgrad der Batterie basierend auf einer Kapazität zu berechnen, die jeder der mehreren erfassten Höhepunkte entspricht, und eine Obergrenze einer Ladebeendigungsspannung für die Batterie gemäß einem Ergebnis des Vergleichs des berechneten Verschlechterungsgrads mit einem voreingestellten Kriteriumsverschlechterungsgrad einzustellen,

   wobei die Steuereinheit (120) konfiguriert ist, um die Obergrenze der Ladebeendigungsspannung so einzustellen, dass sie gleich oder kleiner als eine voreingestellte Kriteriumsspannung ist, wenn der berechnete Verschlechterungsgrad gleich oder größer als der Kriteriumsverschlechterungsgrad ist, und

   wobei die Kriteriumsspannung als eine Spannung eingestellt wird, die einem zweiten Kriteriumshöhepunkt entspricht, der dem zweiten Zielhöhepunkt in dem Kriteriumsprofil entspricht.

2. Batteriemanagementvorrichtung nach Anspruch 1,

   wobei die Steuereinheit konfiguriert ist, um einen ersten Zielhöhepunkt und einen zweiten Zielhöhepunkt in dem Differenzprofil zu erfassen, eine Kapazitätsabweichung zwischen einer ersten Zielkapazität, die dem ersten Zielhöhepunkt entspricht, und einer zweiten Zielkapazität, die dem zweiten Zielhöhepunkt entspricht, zu berechnen und den Verschlechterungsgrad basierend auf der berechneten Kapazitätsabweichung und einer Kriteriumskapazitätsabweichung für ein voreingestelltes Kriteriumsprofil zu berechnen.

3. Batteriemanagementvorrichtung (100) nach Anspruch 2,

   wobei die Steuereinheit (120) konfiguriert ist, um einen Höhepunkt, der in einem ersten Kapazitätsbereich des Kriteriumsprofils unter den mehreren Höhepunkten enthalten ist, als den ersten Zielhöhepunkt zu erfassen und einen Höhepunkt, der in einem zweiten Kapazitätsbereich des Kriteriumsprofils unter den mehreren Höhepunkten enthalten ist, als den zweiten Zielhöhepunkt zu erfassen.

4. Batteriemanagementvorrichtung (100) nach Anspruch 2,

   wobei die Kriteriumskapazitätsabweichung als eine Kapazitätsabweichung zwischen einer ersten Kriteriumskapazität eines ersten Kriteriumshöhepunkts, der dem ersten Zielhöhepunkt in dem Kriteriumsprofil entspricht, und einer zweiten Kriteriumskapazität eines zweiten Kriteriumshöhepunkts, der dem zweiten Zielhöhepunkt entspricht, eingestellt wird.

5. Batteriemanagementvorrichtung (100) nach Anspruch 2,

   wobei die Steuereinheit (120) konfiguriert ist, um die Obergrenze der Ladebeendigungsspannung als eine BOL-Spannung einzustellen, die für die Batterie voreingestellt ist, wenn der berechnete Verschlechterungsgrad kleiner als der Kriteriumsverschlechterungsgrad ist.

6. Batteriemanagementvorrichtung (100) nach Anspruch 5,

   wobei die Kriteriumsspannung als eine Spannung eingestellt wird, die einer zweiten Kriteriumskapazität des zweiten Kriteriumshöhepunkts entspricht.

7. Batteriemanagementvorrichtung (100) nach Anspruch 1,

   wobei, wenn der berechnete Verschlechterungsgrad gleich oder größer als der Kriteriumsverschlechterungsgrad ist, die Steuereinheit (120) konfiguriert ist, um eine Verschlechterungsabweichung zwischen dem berechneten Verschlechterungsgrad und dem Kriteriumsverschlechterungsgrad zu berechnen und eine Spannung, die proportional zu der Verschlechterungsabweichung von der Kriteriumsspannung reduziert ist, als die Obergrenze der Ladebeendigungsspannung einzustellen.

**8.** Batteriemanagementvorrichtung (100) nach Anspruch 7,
wobei die Steuereinheit (120) konfiguriert ist, um die Batterie als einen EOL-Zustand zu diagnostizieren, wenn die berechnete Verschlechterungsabweichung gleich oder größer als eine voreingestellte Schwellenabweichung ist.

**9.** Batteriepack (1) aufweisend die Batteriemanagementvorrichtung (100) nach einem der Ansprüche 1 bis 8.

**10.** Batteriemanagementverfahren umfassend:

einen Differenzprofilerzeugungsschritt des Erzeugens eines Differenzprofils, das eine entsprechende Beziehung zwischen einer Differenzspannung basierend auf Kapazität und Spannung einer Batterie und der Kapazität darstellt;
einen Mehrspitzenerfassungsschritt des Erfassens mehrerer Höhepunkte in dem Differenzprofil;
einen Batterieverschlechterungsgradberechnungsschritt des Berechnens eines Verschlechterungsgrads der Batterie basierend auf einer Kapazität, die jedem der mehreren erfassten Höhepunkte entspricht; und
einen Ladebeendigungsspannungsobergrenzeneinstellschritt des Einstellens einer Obergrenze einer Ladebeendigungsspannung für die Batterie gemäß einem Ergebnis des Vergleichs des berechneten Verschlechterungsgrads mit einem voreingestellten Kriteriumsverschlechterungsgrad,
wobei der Ladebeendigungsspannungsobergrenzeneinstellschritt das Einstellen der Obergrenze der Ladebeendigungsspannungsobergrenze auf kleiner oder gleich einer voreingestellten Referenzspannung umfasst, wenn der berechnete Verschlechterungsgrad größer oder gleich dem Kriteriumsverschlechterungsgrad ist,
wobei die Steuereinheit (120) konfiguriert ist, um die Obergrenze der Ladebeendigungsspannung so einzustellen, dass sie gleich oder kleiner als eine voreingestellte Kriteriumsspannung ist, wenn der berechnete Verschlechterungsgrad gleich oder größer als der Kriteriumsverschlechterungsgrad ist, und
wobei die Kriteriumsspannung als eine Spannung eingestellt wird, die einem zweiten Kriteriumshöhepunkt entspricht, der dem zweiten Zielhöhepunkt in dem Kriteriumsprofil entspricht.

**Revendications**

**1.** Appareil de gestion de batterie (100), comprenant :

un module de génération de profil (110) configuré pour obtenir des informations sur la batterie concernant la capacité et la tension d'une batterie, et générer un profil différentiel représentant une relation correspondante entre la capacité et une tension différentielle sur la base de la capacité et de la tension ; et
un module de commande (120) configuré pour obtenir le profil différentiel à partir du module de génération de profil (110), détecter une pluralité de pics dans le profil différentiel obtenu, calculer un degré de dégradation de la batterie en fonction d'une capacité correspondant à chacun de la pluralité de pics détectés, et définir une limite supérieure d'une tension de fin de charge pour la batterie en fonction d'un résultat de la comparaison du degré de dégradation calculé avec un degré de dégradation critère prédéfini,
le module de commande (120) étant configuré pour définir la limite supérieure de la tension de fin de charge afin qu'elle soit égale ou inférieure à une tension critère prédéfinie, lorsque le degré de dégradation calculé est égal ou supérieur au degré de dégradation critère, et
la tension critère étant définie comme une tension correspondant à un deuxième pic critère correspondant au deuxième pic cible dans le profil critère.

**2.** Appareil de gestion de batterie selon la revendication 1,
le module de commande étant configuré pour détecter un premier pic cible et un deuxième pic cible dans le profil différentiel, calculer un écart de capacité entre une première capacité cible correspondant au premier pic cible et une deuxième capacité cible correspondant au deuxième pic cible, et calculer le degré de dégradation en fonction de l'écart de capacité calculé et d'un écart de capacité critère pour un profil critère prédéfini.

**3.** Appareil de gestion de batterie (100) selon la revendication 2,
le module de commande (120) étant configuré pour détecter un pic inclus dans une première zone de capacité du profil critère parmi la pluralité de pics, en tant que premier pic cible, et détecter un pic inclus dans une deuxième zone de capacité du profil critère parmi la pluralité de pics en tant que deuxième pic cible.

**4.** Appareil de gestion de batterie (100) selon la revendication 2,
l'écart de capacité critère étant défini comme un écart de capacité entre une première capacité critère d'un premier pic critère correspondant au premier pic cible dans le profil critère et une deuxième capacité critère d'un deuxième pic critère correspondant au deuxième pic cible.

5. Appareil de gestion de batterie (100) selon la revendication 2,
le module de commande (120) étant configuré pour définir la limite supérieure de la tension de fin de charge en tant que tension BOL préétablie pour la batterie, lorsque le degré de dégradation calculé est inférieur au degré de dégradation critère.

6. Appareil de gestion de batterie (100) selon la revendication 5,
la tension critère étant définie comme une tension correspondant à une deuxième capacité critère du deuxième pic critère.

7. Appareil de gestion de batterie (100) selon la revendication 1,
le degré de dégradation calculé étant égal ou supérieur au degré de dégradation critère, le module de commande (120) étant configuré pour calculer un écart de dégradation entre le degré de dégradation calculé et le degré de dégradation critère, et définir une tension réduite proportionnellement à l'écart de dégradation relativement à la tension critère en tant que limite supérieure de la tension de fin de charge.

8. Appareil de gestion de batterie (100) selon la revendication 7,
le module de commande (120) étant configuré pour diagnostiquer la batterie comme étant dans un état EOL, lorsque l'écart de dégradation calculé est égal ou supérieur à un écart de seuil prédéfini.

9. Bloc-batterie (1) comprenant l'appareil de gestion de la batterie (100) selon une quelconque des revendications 1 à 8.

10. Procédé de gestion d'une batterie, comprenant :

une étape de génération d'un profil différentiel comportant la génération d'un profil différentiel représentant une relation correspondante entre une tension différentielle basée sur la capacité et la tension d'une batterie et la capacité; et
une étape de détection de pics multiples comportant la détection d'une pluralité de pics dans le profil différentiel ;
une étape de calcul du degré de dégradation de la batterie consistant à calculer un degré de dégradation de la batterie d'après une capacité correspondant à chacun de la pluralité de pics détectés ; et
une étape de définition d'une limite supérieure de la tension de fin de charge consistant à définir une limite supérieure d'une tension de fin de charge pour la batterie en fonction d'un résultat de la comparaison du degré de dégradation calculé avec un degré de dégradation de critère prédéfini,
l'étape de définition de la limite supérieure de la tension de fin de charge comprenant l'établissement de la limite supérieure de la limite supérieure de tension de fin de charge à un degré inférieur ou égal à une tension de référence prédéfinie lorsque le degré de dégradation calculé est supérieur ou égal au degré de dégradation critère,
le module de commande (120) étant configuré pour définir la limite supérieure de la tension de fin de charge afin qu'elle soit égale ou inférieure à une tension critère prédéfinie, lorsque le degré de dégradation calculé est égal ou supérieur au degré de dégradation critère, et
la tension critère étant définie comme une tension correspondant à un deuxième pic critère correspondant au deuxième pic cible dans le profil de critère.

FIG. 1

FIG. 2

FIG. 3

FIG. 4

START

DIFFERENTIAL PROFILE
GENERATING STEP ~S100

PLURAL PEAK DETECTING STEP ~S200

BATTERY DEGRADATION DEGREE
CALCULATING STEP ~S300

CHARGE TERMINATION VOLTAGE
UPPER LIMIT SETTING STEP ~S400

END

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020210010308

- JP 5940145 A